(19) Europäisches Patentamt
European Patent Office
Office européen des brevets

(11) **EP 4 316 844 A1**

(12) **EUROPEAN PATENT APPLICATION**
published in accordance with Art. 153(4) EPC

(43) Date of publication:
**07.02.2024 Bulletin 2024/06**

(21) Application number: **22780506.6**

(22) Date of filing: **24.03.2022**

(51) International Patent Classification (IPC):
***B41C 1/00*** (2006.01)          ***B41N 1/00*** (2006.01)
***C08F 279/02*** (2006.01)        ***G03F 7/00*** (2006.01)
***G03F 7/027*** (2006.01)

(52) Cooperative Patent Classification (CPC):
**B41C 1/00; B41N 1/00; C08F 279/02; G03F 7/00; G03F 7/027**

(86) International application number:
**PCT/JP2022/014109**

(87) International publication number:
**WO 2022/210292 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2021 JP 2021060602**

(71) Applicant: **TOYOBO MC Corporation**
**Osaka 530-0001 (JP)**

(72) Inventors:
• **WATANABE, Tomoko**
  **Okayama-shi, Okayama 704-8194 (JP)**
• **YOSHIMOTO, Kazuya**
  **Okayama-shi, Okayama 704-8194 (JP)**

(74) Representative: **Müller-Boré & Partner**
**Patentanwälte PartG mbB**
**Friedenheimer Brücke 21**
**80639 München (DE)**

(54) **PHOTOSENSITIVE RESIN COMPOSITION FOR FLEXOGRAPHIC PRINTING ORIGINAL PLATES, AND FLEXOGRAPHIC PRINTING ORIGINAL PLATE OBTAINED USING SAID COMPOSITION**

(57)    The present invention aims to provide a photosensitive resin composition for a flexographic printing original plate that can maintain durability against aqueous ink while having high water-developability, and a flexographic printing original plate obtained therefrom. A photosensitive resin composition for a flexographic printing original plate, wherein the photosensitive resin composition contains at least: a conjugated diene-based polymer (a) obtained from water-dispersible latex; a photopolymerizable unsaturated compound (b); a diene-based polymer (c) having a terminal carboxyl group; and a photopolymerization initiator (d), characterized in that the terminal carboxyl group of the diene-based polymer (c) having a terminal carboxyl group is a metal salt.

EP 4 316 844 A1

**Description**

Technical Field of the Invention

The present invention relates to a photosensitive resin composition for a flexographic printing original plate having excellent water-developability and excellent ink resistance, and a flexographic printing original plate obtained therefrom.

Background Art

A flexographic printing original plate normally has a structure including a photosensitive resin layer on a support. A photosensitive resin composition that forms the photosensitive resin layer generally contains as essential components a polymer compound such as elastomer, a photopolymerizable unsaturated compound, and a photopolymerization initiator, and contains additives such as a stabilizer and a plasticizer blended therein as necessary.

As to conventional photosensitive resin plates for flexographic printing, those to be developed with an organic solvent are known. These printing plates, however, have had problems of safety to humans and environment, such as toxicity and inflammability. Therefore, proposed as a replacement of these printing plates is a water-developable photosensitive resin composition. For example, Patent Literature 1 proposes a photosensitive resin composition containing a hydrophobic polymer obtained from at least two types of water-dispersible latex, a hydrophilic polymer, a photopolymerizable compound, and a conjugated diene oligomer having no crosslinking group.

The photosensitive resin composition of Patent Document 1, however, has had a problem of requiring a long time for development and thus lowering operability. There has also been a problem of lowering image reproducibility of a fine relief due to scrubbing the surface of the relief with a brush for a long time in a developing step.

Then, proposed in Patent Document 2 to improve the water-developability is a photosensitive resin composition containing water-dispersible latex, rubber, a surfactant, a photopolymerizable monomer, and a photopolymerization initiator, with a sulfonic acid-based surfactant used as the surfactant. Further, proposed in Patent Document 3 to improve water resistance and printing resistance is a photosensitive resin composition containing a hydrophilic copolymer, elastomer, a polymerizable unsaturated monomer, a plasticizer that contains a polymer having a carboxyl group in at least one repeating unit derived from a conjugated diene compound, and a photopolymerization initiator.

These photosensitive resin compositions improve the water-developability when the content of a hydrophilic group-containing component is increased, but such an increase also increases hydrophilicity of the cured printing plate. Therefore, a problem of these photosensitive resin compositions has been that when flexographic printing is performed with general aqueous ink, the printing plate is swollen or softened with water, changing reproducibility and/or tone of printed matter in the middle of mass printing and remarkably lowering printing quality.

Prior Art Documents

Patent Documents

Patent Document 1: Japanese Patent Application Laid-Open (JP-A) No. 2005-148588
Patent Document 2: Japanese Patent Application Laid-Open (JP-A) No. 2011-203453
Patent Document 3: Japanese Patent Application Laid-Open (JP-A) No. 2017-76059

Disclosure of the Invention

Problem that the Invention is to Solve

The present invention has been conceived of in view of the present state of the conventional techniques described above. An object of the present invention is to provide a photosensitive resin composition for a flexographic printing original plate that can maintain durability against aqueous ink while having high water-developability, and a flexographic printing original plate obtained therefrom.

Means for Solving the Problem

As a result of earnest study to achieve the object, the inventors of the present invention have found that by using a photosensitive resin composition containing, in addition to a conjugated diene-based polymer obtained from water-dispersible latex, a diene-based polymer having a terminal carboxyl group of a metal salt, it is possible to make the flexographic printing original plate have higher water-developability than that achieved by using conventional photosensitive resin compositions and improve the durability against aqueous ink. The present invention has thus been completed.

Thus, the present invention is constituted from the following (1) to (7).

(1) A photosensitive resin composition for a flexographic printing original plate, wherein the photosensitive resin composition contains at least: a conjugated diene-based polymer (a) obtained from water-dispersible latex; a photopolymerizable unsaturated compound (b); a diene-based polymer (c) having a terminal carboxyl group; and a photopolymerization initiator (d), characterized in that the terminal carboxyl group of the diene-based polymer (c) having a terminal carboxyl group is a metal salt.

(2) The photosensitive resin composition for a flexographic printing original plate according to (1), wherein the component (c) contains an acrylonitrile skeleton and has a bound acrylonitrile content of 15 mol% or more in the component (c) .

(3) The photosensitive resin composition for a flexographic printing original plate according to (1) or (2), wherein the metal salt of the component (c) is an alkali metal salt.

(4) The photosensitive resin composition for a flexographic printing original plate according to any one of (1) to (3), wherein the component (c) is contained in a proportion of 1 to 30 mass% in the total components of the photosensitive resin composition.

(5) The photosensitive resin composition for a flexographic printing original plate according to any one of (1) to (4), wherein the component (a) contains at least one type of latex selected from the group consisting of butadiene latex, acrylonitrile-butadiene latex, styrene-butadiene latex, and isoprene latex.

(6) The photosensitive resin composition for a flexographic printing original plate according to any one of (1) to (5), wherein the component (a) contains butadiene latex and acrylonitrile-butadiene latex.

(7) A flexographic printing original plate characterized by comprising, on a support, a photosensitive resin layer produced by using the photosensitive resin composition for a flexographic printing original plate according to any one of (1) to (6) .

Effects of the Invention

The photosensitive resin composition for a flexographic printing original plate according to the present invention has a feature of having higher water-developability (in terms of developing speed, etc.) than that of conventionally known photosensitive resin compositions, and having durability against aqueous ink, and can therefore provide a flexographic printing original plate suitable for high-quality mass printing.

Mode for Carrying Out the Invention

The photosensitive resin composition for a flexographic printing original plate according to the present invention contains a conjugated diene-based polymer (a) obtained from water-dispersible latex; a photopolymerizable unsaturated compound (b); a diene-based polymer (c) having a terminal carboxyl group; and a photopolymerization initiator (d), and is characterized in that the terminal carboxyl group of the component (c) is a metal salt, and preferably an alkali metal salt.

As to the conjugated diene-based polymer (a) obtained from water-dispersible latex, a conventionally known synthetic polymer compound used for a flexographic printing original plate can be used. Specific examples thereof include a polymer obtained by polymerizing a conjugated diene-based hydrocarbon, and a copolymer obtained by copolymerizing a conjugated diene-based hydrocarbon and a monoolefin-based unsaturated compound. Examples thereof include a butadiene polymer, an isoprene polymer, a chloroprene polymer, a styrene-butadiene copolymer, a styrene-butadiene-styrene copolymer, a styrene-isoprene copolymer, a styrene-isoprene-styrene copolymer, a styrene-chloroprene copolymer, an acrylonitrile-butadiene copolymer, an acrylonitrile-isoprene copolymer, a methyl methacrylate-butadiene copolymer, a methyl methacrylate-isoprene copolymer, an acrylonitrile-butadiene-styrene copolymer, and an acrylonitrile-isoprene-styrene copolymer. These polymers may be copolymerized with a carboxyl group, a sulfonic acid group, or a hydrophilic group of a polyalkylene glycol or the like, or may have a hydrophilic functional group obtained by emulsion polymerization. As to the component (a), two or more types of polymers may be used in combination. From the viewpoint of the characteristics of a flexographic printing plate, such as rebound resilience of the surface of a plate, strength-elongation properties, hardness of a resin plate, form stability of an unexposed plate, and water-developability, the component (a) is preferred to contain at least one type of latex selected from the group consisting of butadiene latex, acrylonitrile-butadiene latex, styrene-butadiene latex, and isoprene latex. The component (a) is further preferred to contain both butadiene latex and acrylonitrile-butadiene latex in terms of water-developability.

The conjugated diene-based polymer (a) obtained from water-dispersible latex has a role of imparting strength to a printing plate. As to the component having such a role, generally used is an elastomer synthesized by solution polymerization, in addition to the conjugated diene-based polymer obtained from water-dispersible latex. Used in the present invention, however, is the conjugated diene-based polymer obtained from water-dispersible latex but not the elastomer synthesized by solution polymerization. The conjugated diene-based polymer obtained from water-dispersible latex is synthesized by emulsion polymerization and therefore has a smaller particle size than that of the elastomer synthesized by solution polymerization. Accordingly, by using the conjugated diene-based polymer obtained from water-dispersible latex, the water-developability can be improved compared to when the elastomer synthesized by solution polymerization is used.

The conjugated diene-based polymer (a) obtained from water-dispersible latex is preferred to be intramolecularly crosslinked. The conjugated diene-based polymer (a) may, as desired, be modified with a (meth)acryl group, a carboxyl group, silicone, fluorine, or the like. The water-dispersible latex may appropriately be selected from a variety of types of synthetic latex and natural latex that are commercially available.

The blending amount of the component (a) in the photosensitive resin composition according to the present invention is preferred to be 10 to 80 mass%, and more preferred to be 20 to 75 mass%. With the blending amount of the component (a) less than the above range, the printing plate may possibly have insufficient strength. With the blending amount more than the above range, development with water may possibly take time.

As to the photopolymerizable unsaturated compound (b), one that is used for a flexographic printing original plate and is conventionally known can be used. The photopolymerizable unsaturated compound (b) is preferred to contain a photopolymerizable monomer such as a meth(acrylate) having a number-average molecular weight of 100 or more and 600 or less. The photopolymerizable unsaturated compound (b) is further preferred to contain, in addition to the photopolymerizable monomer, a photopolymerizable oligomer such as a (meth)acrylate having a number-average molecular weight of more than 600 and 20000 or less. Here, the photopolymerizable monomer is crosslinked and cured by a photopolymerization initiator and thus forms a dense crosslinking network, while the photopolymerizable oligomer is crosslinked and cured by a photopolymerization initiator and thus forms a moderate crosslinking network.

The photopolymerizable monomer is not particularly limited as long as it has a number-average molecular weight in a range of 100 or more and 600 or less . Examples thereof include linear, branched, or cyclic monofunctional monomers such as hexyl (meth)acrylate, nonane (meth)acrylate, lauryl (meth)acrylate, stearyl (meth)acrylate, 2-ethyl, 2-butylpropanediol (meth)acrylate, hydroxyethyl (meth) acrylate, 2-(meth)acryloyloxyethyl hexahydrophthalate, 2-(meth)acryloyloxyethyl phthalate, a (meth)acrylic acid dimer, an ECH-modified allyl acrylate, benzyl acrylate, caprolactone (meth)acrylate, dicyclopentenyl (meth)acrylate, isobornyl (meth)acrylate, and cyclohexyl (meth)acrylate. Examples thereof also include linear, branched, or cyclic polyfunctional monomers such as hexanediol di(meth)acrylate, nonanediol di(meth)acrylate, 2-butyl-2-ethylpropane di(meth)acrylate, neopentyl glycol di(meth)acrylate, hydroxypivalic acid neopentyl glycol di(meth)acrylate, ECH-modified phthalic acid di(meth)acrylate, dicyclopentadiene di(meth) acrylate, tricyclodecanedimethanol di(meth)acrylate, trimethylolpropane tri(meth)acrylate, pentaerythritol tri(meth)acrylate, ECH-modified glycerol tri(meth)acrylate, trimethylolpropanebenzoate (meth)acrylate, EO (PO)-modified trimethylolpropane tri(meth)acrylate, and dipentaerythritol hexa(meth)acrylate. These compounds may be used singly, or two or more thereof may be used in combination so as to impart aimed resin properties.

The photopolymerizable oligomer is not particularly limited as long as it has a number-average molecular weight in a range of more than 600 and 20000 or less. Examples thereof include one obtained by adding a (meth)acrylate group to a butadiene oligomer or an isoprene oligomer, and urethane (meth) acrylate. These compounds may be used singly, or two or more thereof may be used in combination so as to impart aimed resin properties.

The blending amount of the component (b) in the photosensitive resin composition according to the present invention is preferred to be 5 to 45 mass%, and more preferred to be 8 to 35 mass%. With the blending amount of the component (b) less than the above range, toughness may possibly be degraded. With the blending amount more than the above range, the developability may possibly be degraded.

The diene-based polymer (c) having a terminal carboxyl group has a terminal -COOM group (wherein M represents a metal), and is different from the component (a) . Due to the structure of the diene-based polymer, rebound resilience of the surface of a plate, strength-elongation properties, hardness of a resin plate, form stability of an unexposed plate, and durability against aqueous ink during printing can be obtained. In addition, due to the terminal carboxyl group, steric hindrance is prevented, the hydrophilicity is increased, water molecules can strongly be attracted in development with water, and thus good water-developability can be obtained. This effect is further improved by neutralization through converting the terminal carboxyl group into a metal salt. Preferred as the metal salt are alkali metal salts of lithium, sodium, potassium, or the like. As to a compound used to convert at least a part of the carboxyl groups into a metal salt, a conventionally known alkali metal carbonate salt or alkali metal hydroxide salt is preferred to be used. Examples of such a compound include hydroxides of alkali metals, such as lithium hydroxide, sodium hydroxide, and potassium hydroxide. The conversion into a salt with the alkali metal salt can give better water-developability than that given by conversion into a salt with an alkaline-earth metal salt or the like. The conversion into a salt with a metal salt improves the durability against aqueous ink compared to that of a compound obtained by neutralizing the terminal carboxyl group with an amine or an amino compound. This is considered to be due to pseudo crosslinking formed by a metal ion.

Specific examples of the diene-based polymer having a terminal carboxyl group include a polymer obtained by polymerizing a conjugated diene-based hydrocarbon, and a compound obtained by copolymerizing a conjugated diene-based hydrocarbon and a monoolefin-based unsaturated compound to obtain a conjugated diene copolymer, and modifying an end of the conjugated diene copolymer with a monomer having a carboxyl group. Examples thereof include compounds obtained by modifying, with a monomer having a carboxyl group, an end of a butadiene polymer, an isoprene polymer, a chloroprene polymer, a styrene-butadiene copolymer, a styrene-butadiene-styrene copolymer, a styrene-isoprene copolymer, a styrene-isoprene-styrene copolymer, a styrene-chloroprene copolymer, an acrylonitrile-butadiene copolymer, an acrylonitrile-isoprene copolymer, an acrylonitrile-butadiene-styrene copolymer, or an acrylonitrile-isoprene-styrene copolymer. Among these examples, a compound is preferred that is obtained by modifying, with a monomer having a carboxyl group, an end of a conjugated diene copolymer containing an acrylonitrile skeleton because, due to such a compound having polarity, the hydrophilicity is improved and thus good development with water can be obtained. The diene-based polymer having a terminal carboxyl group is desired to have a bound acrylonitrile content of 15 mol% or more, and more preferably 25 mol% or more, in terms of polarity-attributed hydrophilicity. The upper limit of the bound acrylonitrile content is preferred to be 40 mol%. With the bound acrylonitrile content more than 40 mol%, the relief may possibly have degraded water resistance. From the viewpoint of bound resilience of the surface of a plate, strength-elongation properties, hardness of a resin plate, and the like, the diene-based polymer having a terminal carboxyl group is preferred to have a butadiene skeleton. The diene-based polymer having a terminal carboxyl group is desired to have a number-average molecular weight of preferably about 1000 to 30000, more preferably 1000 to 20000, and particularly 1000 to 6000. As to the diene-based polymer having a terminal carboxyl group, the compounds may be used singly, or in combination of two or more thereof as necessary, or may be modified as necessary.

The blending amount of the component (c) in the photosensitive resin composition according to the present invention is preferred to be 1 to 30 mass%, and more preferred to be 5 to 28 mass%. With the blending amount of the component (c) less than the above range, the effects of adding the component (c) may not possibly be exhibited sufficiently. With the blending amount more than the above range, the relief may possibly have degrade water resistance. The blending ratio in mass between the components (a) and (c) in the photosensitive resin composition according to the present invention is preferred to be component (a) : component (c) = 1.2 : 1 to 10 : 1, and more preferred to be 1.5 : 1 to 9 : 1. With the blending ratio of the component (c) to the component (a) excessively low, the effect of improving the water-developability by the component (c) may not possibly be exhibited sufficiently, whereas with this blending ratio excessively high, the relief may possibly have degraded water resistance.

The photopolymerization initiator (d) is not particularly limited as long as it can polymerize a polymerizable carbon-carbon unsaturated group by light. Especially, one having functions of causing self decomposition by absorption of light or generating a radical by hydrogen abstraction is preferred to be used. Specific examples of such a photopolymerization initiator include a benzoin alkyl ether, a benzophenone, an anthraquinone, a benzil, an acetophenone, and a diacetyl. The blending amount of the component (d) in the photosensitive resin composition according to the present invention is preferred to be 0.1 to 10 mass%, and more preferred to be 0.3 to 5 mass%. With the blending amount of the component (d) less than the above range, initiation efficiency may be decreased and image reproducibility may possibly become poor. With the blending amount more than the above range, sensitivity may be increased and a control of exposure time may possibly become difficult.

The photosensitive resin composition according to the present invention may appropriately contain, in addition to the components (a) to (d), other components such as a plasticizer, a UV absorber, a thermal polymerization inhibitor (stabilizer), thermoplastic resin elastomer, solid rubber, a dye, a pigment, a defoamer, a flocculation inhibitor, a silicone compound, and a fluorine compound for the purpose of improving various characteristics, as far as the effects of the present invention are not inhibited thereby.

The plasticizer imparts softness to the photosensitive resin layer. Examples of the plasticizer include liquid rubber, oil, polyester, and a phosphoric acid-based compound. Examples of the liquid rubber include liquid compounds having a conjugated diene-based structure, and those obtained by adding a hydroxyl group, a carboxyl group, or a sulfonic acid group to these liquid compounds. Examples of the oil include paraffin, a naphthene, and aroma oil. Examples of the polyester include adipic acid-based polyester. Examples of the phosphoric acid-based compound include phosphoric acid ester. Among these examples, liquid polybutadiene and liquid polybutadiene having a hydroxyl group or a carboxyl group added thereto are preferred from the viewpoint of compatibility with the polymer obtained by polymerizing a conjugated diene. When development is performed with an aqueous developer, liquid polybutadiene having a hydroxyl group or a carboxyl group added thereto is particularly preferred. The blending amount of the plasticizer in the photosensitive resin composition according to the present invention is 15 mass% at most.

The UV absorber widens tolerance of time for exposing the photosensitive resin layer. Examples of the UV absorber include benzophenone-based, salicylate-based, benzotriazole-based, acrylonitrile-based, metal complex salt-based, hindered amine-based, anthraquinone-based, azo-based, coumarin-based, or furan-based compounds. Among these examples, benzotriazole-based compounds are preferred from the viewpoint of exposure latitude. The blending amount of the UV absorber in the photosensitive resin composition according to the present invention is 0.1 mass% at most.

The thermal polymerization inhibitor (stabilizer) increases thermal stability during kneading and/or storage stability. Examples thereof include a phenol, a hydroquinone, and a catechol. The blending amount of the thermal polymerization inhibitor (stabilizer) in the photosensitive resin composition according to the present invention is 5 mass% at most.

The flexographic printing original plate according to the present invention has a structure comprising, on a support, a photosensitive resin layer produced by using a photosensitive resin composition containing the components described above. The flexographic printing original plate can be produced by molding a photosensitive resin layer through a melt molding method or, for example, heat pressing or injection, or any known method such as melt extrusion and solution casting, and stacking this molded photosensitive resin layer on a support with an adhesive layer therebetween. When a laminate obtained by stacking the photosensitive resin layer on the support is supplied, a protective layer (cover film) is preferred to be further stacked on the photosensitive resin layer. As to the support, conventionally known stainless steel, aluminum, glass, a plastic film such as a polyester film, or the like can be used, but a film having a thickness in a range of 50 to 500 um is generally used. Used as the protective layer is one obtained by providing, on a plastic film, for example, a 125-$\mu$m-thick polyester film, a slip coat layer mainly made from polyvinyl alcohol, or by applying an infrared abrasion layer onto a plastic film. The protective layer can also be provided between the infrared abrasion layer and the photosensitive resin layer.

The flexographic printing original plate according to the present has the polyester film as the upper most layer. The film is peeled therefrom to leave a polyvinyl alcohol membrane on the photosensitive resin layer. Then, a negative film including an image is closely attached onto the membrane or an image is drawn on the infrared abrasion layer by an imaging device. Then, exposure is performed from above the membrane or the layer by irradiation with an active light beam. This process makes only the exposed portion undissolved and cured. For the active light beam, it is preferred to use a light source, such as a high-pressure mercury lamp, a super high-pressure mercury lamp, a metal halide lamp, a xenon lamp, and a chemical lamp, normally having a main wavelength of 300 to 450 nm. Next, the non-exposed potion is dissolved and removed with an appropriate solvent or water containing a surfactant added thereto. As a result, a printing plate having a clear image portion is obtained. For the dissolution and removal, it is preferred to use a spray developing device, a brush developing device, or the like.

Examples

The effects of the flexographic printing original plate produced by using the photosensitive resin composition according to the present invention are described by way of the following examples. The present invention, however, is not limited to these examples. The values of the ratio in composition shown in the table represent parts by mass of solid components after the solvent is volatilized.

(Example 1)

Production of metal salt product of diene-based polymer (c) having terminal carboxyl group

An acrylonitrile-butadiene oligomer wherein both terminals thereof have been modified with carboxyl groups (Hypro 1300X13 CTBN, bound acrylonitrile content 26 mol%, manufactured by CHORI GLEX Co., Ltd.) in an amount of 25 parts by mass was dissolved in the same amount of tetrahydrofuran. Lithium hydroxide in an equimolar amount to the contained amount of carboxyl groups was added under stirring and further stirred for 30 minutes, so as to give a metal salt product of the diene-based polymer (c) having a terminal carboxyl group.

Production of photosensitive resin composition

Mixed in a container were 39 parts by mass of butadiene latex (Nipol LX111NF, non-volatile content 55%, manufactured by Zeon Corporation) and 6 parts by mass of carboxyl-modified acrylonitrile-butadiene latex (Nipol SX1503, non-volatile content 42%, manufactured by Zeon Corporation) as the conjugated diene-based polymer (a) obtained from water-dispersible latex, 17 parts by mass of oligobutadiene acrylate (ABU-4S, manufactured by Kyoeisha Chemical Co., Ltd.) and 6.4 parts by mass of trimethylolpropane trimethacrylate (Light Ester TMP, manufactured by Kyoeisha Chemical Co., Ltd.) as the photopolymerizable unsaturated compound (b), 25 parts by mass of the above-prepared metal salt product of the diene-based polymer (c) having a terminal carboxyl group, 1 part by mass of the photopolymerization initiator (d) (Irgacure 651), and 5.5 parts by mass of a butadiene oligomer (LBR-352, manufactured by Kuraray Co., Ltd.) and 0.1 parts by mass of a thermal stabilizer (4-methoxyphenol) as other components. As a result, a dope was prepared. The dope was charged into a pressure kneader and had tetrahydrofuran and water removed therefrom at 80°C under reduced pressure, so as to obtain a photosensitive resin composition.

Production of flexographic printing original plate

The photosensitive resin composition was placed on a PET film support (TOYOBO CO., LTD., E5000, thickness 125 $\mu$m) coated with a copolymerized polyester-based adhesive, and a film laminate coated with a protective-layer coating solution (thickness of dried coating film was 2.0 $\mu$m) was layered on the photosensitive resin composition. The layered laminate was laminated using a heat pressing machine at 100°C, so as to give a flexographic printing original plate formed of the PET support, the adhesive layer, the photosensitive resin layer, the protective layer, and the cover film. The plate had a total thickness of 1.70 mm.

Production of flexographic printing plate from flexographic printing original plate

The cover film was peeled from the flexographic printing original plate. A negative film was put in a half of the plate. The plate was irradiated with a chemical ray (light source Philips10R, illuminance at 365 nm of 8 mW/cm$^2$) for 10 minutes. Thereafter, the plate was developed by a developing machine (Stuck System, 1% aqueous solution of washing soap, 40°C) manufactured by A & V Co., Ltd. for 7 minutes. Then, water drops on the surface of the plate were removed by a water draining rod. Thereafter, the plate was dried by a drier at 60°C for 10 minutes, irradiated with a chemical ray for 10 minutes, and finally irradiated by a sterilizing lamp for 5 minutes so as to remove adhesiveness on the surface. As a result, a flexographic printing plate was obtained.

(Examples 2 to 12) and (Comparative Examples 1 to 5)

Photosensitive resin compositions, flexographic printing original plates, and flexographic printing plates were produced in the same manner as in Example 1 except that the composition of the photosensitive resin layer (photosensitive resin composition) in the printing original plate was changed as shown in Table 1. The detail of the styrene-butadiene latex used in Examples as the conjugated diene-based polymer (a) obtained from water-dispersible latex is as follows: Nipol LX110, non-volatile content 410, manufactured by Zeon Corporation.

The detail of diene-based polymers (c) having a terminal carboxyl group and diene-based polymers having no terminal carboxyl group shown in Table 1 is as follows. The metal (lithium hydroxide, sodium hydroxide, sodium carbonate, and calcium carbonate) used for converting carboxyl groups in the diene-based polymer (c) having a terminal carboxyl group into a metal salt was added in an equimolar amount to the contained amount of carboxyl groups in the diene-based polymer (c) having a terminal carboxyl group.

Diene-based polymer (c) having terminal carboxyl group

Acrylonitrile-butadiene copolymer I wherein both terminals thereof have been modified with carboxyl groups: Hypro 1300X13 CTBN, bound acrylonitrile content 26 mol%, manufactured by CHORI GLEX Co., Ltd.

Acrylonitrile-butadiene copolymer II wherein both terminals thereof have been modified with carboxyl groups: Hypro 1300X8 CTBN, bound acrylonitrile content 18 mol%, manufactured by CHORI GLEX Co., Ltd.

Acrylonitrile-butadiene copolymer III wherein both terminals thereof have been modified with carboxyl groups: Hypro 1300X31 CTBN, bound acrylonitrile content 10 mol%, manufactured by CHORI GLEX Co., Ltd.

Butadiene polymer wherein both terminals thereof have been modified with carboxyl groups: a compound obtained by an addition reaction of maleic anhydride to hydroxyl groups at both terminals of a butadiene oligomer wherein both terminals thereof have been modified with hydroxyl groups (G1000, Nippon Soda Co., Ltd.)

Isoprene polymer wherein both terminals thereof have been modified with carboxyl groups: a compound obtained by an addition reaction of maleic anhydride to hydroxyl groups at both terminals of polyisoprene wherein both terminals thereof have been modified with hydroxyl groups (Poly ip, manufactured by Idemitsu Kosan Co., Ltd.)

Diene-based polymer having no terminal carboxyl group

Acrylonitrile-butadiene copolymer wherein both terminals thereof have been modified with amino groups: Hypro 1300X16 ATBN, bound acrylonitrile content 18 mol%, manufactured by CHORI GLEX Co., Ltd.

Acrylonitrile-butadiene copolymer containing carboxyl group in repeating unit: PFT-4, non-volatile content 25%, manufactured by Kyoeisha Chemical Co., Ltd.

Isoprene polymer containing carboxyl group in repeating unit: LIR-410, manufactured by Kuraray Co., Ltd.

(Comparative Example 6)

A photosensitive resin composition, a flexographic printing original plate, and a flexographic printing plate were produced in the same manner as in Example 7 except that an amine product of the diene-based polymer having a terminal carboxyl group was used in place of the metal salt product of the diene-based polymer having a terminal carboxyl group. Used as the amine product of the diene-based polymer having a terminal carboxyl group was one obtained by neutralizing, with di-n-butylamine, terminal carboxyl groups of the acrylonitrile-butadiene copolymer II wherein both terminals thereof have been modified with carboxyl groups: Hypro 1300X8 CTBN, bound acrylonitrile content 18 mol%, manufactured by CHORI GLEX Co., Ltd.

The flexographic printing plates of Examples 1 to 12 and Comparative Examples 1 to 6 were evaluated for durability against aqueous ink and water-developability by the following methods. Table 1 shows the results.

(1) Durability against aqueous ink

A 2 cm × 5 cm piece was cut out from a convex portion of the relief, measured for weight (weight before swollen), and immersed in water at 25°C for 1 day. Then, water adhered to the piece was wiped therefrom, and the piece was immediately measured for weight (weight after swollen) . A water absorption rate was obtained by the following equation (I). The water absorption rate was defined as an index of the durability against aqueous ink.

$$\text{Equation (I) : water absorption rate (\%)} = [(\text{weight after swollen}) - (\text{weight before swollen})]/(\text{weight before swollen}) \times 100$$

The lower the water absorption rate is, the more excellent the durability against aqueous ink is.

(2) Water-developability

The produced flexographic printing plate was measured for distance scraped through the development, with the convex portion defined as 0 mm, whereby the depth of the relief was obtained. The depth of the relief was defined as an index of the water-developability. The greater the depth of the relief is, the more excellent the water-developability is.

[Table 1]

| | | | | Examples | | | | | |
|---|---|---|---|---|---|---|---|---|---|
| | | | | 1 | 2 | 3 | 4 | 5 | 6 |
| Composition of photosensitive resin layer | Conjugated diene-based polymer (a) obtained from water-dispersible latex | | Butadiene latex | 39.0 | 42.0 | 45.0 | 45.0 | 45.0 | 45.0 |
| | | | Acrylonitrile-butadiene latex | 6.0 | 7.0 | 9.7 | 9.7 | 9.7 | 9.7 |
| | | | Styrene-butadiene latex | | | | | | |
| | Photopolymerizable unsaturated compound (b) | | Oligobutadiene acrylate | 17.0 | 19.0 | 19.0 | 19.0 | 19.0 | 19.0 |
| | | | Trimethylolpropane trimethacrylate | 6.4 | 7.5 | 7.5 | 7.5 | 7.5 | 7.5 |
| | Diene-based polymer (c) having a terminal carboxyl group | | Acrylonitrile-butadiene copolymer I wherein both terminals thereof have been modified with carboxyl groups | 25.0 | 13.7 | 7.0 | 7.0 | 7.0 | 7.0 |
| | | | Acrylonitrile-butadiene copolymer II wherein both terminals thereof have been modified with carboxyl groups | | | | | | |
| | | | Acrylonitrile-butadiene copolymer III wherein both terminals thereof have been modified with carboxyl groups | | | | | | |
| | | | Butadiene polymer wherein both terminals thereof have been modified with carboxyl groups | | | | | | |
| | | | Isoprene polymer wherein both terminals thereof have been modified with carboxyl groups | | | | | | |
| | Diene-based polymer having no terminal carboxyl group | | Acrylonitrile-butadiene copolymer wherein both terminals thereof have been modified with amino groups | | | | | | |
| | | | Acrylonitrile-butadiene copolymer containing carboxyl group in repeating unit | | | | | | |
| | | | Isoprene polymer containing carboxyl group in repeating unit | | | | | | |
| | Photopolymerization initiator (d) | | | 1 | 1 | 1 | 1 | 1 | 1 |
| | Metal used to convert carboxyl groups in the diene-based polymer (c) having a terminal carboxyl group into a metal salt | | | LiOH | LiOH | LiOH | NaOH | Na₂CO₃ | CaCO₃ |
| | Plasticizer | | Butadiene oligomer | 5.5 | 9.7 | 10.7 | 10.7 | 10.7 | 10.7 |
| Evaluation | | | Water absorption rate (Durability against aqueous ink) | 1.7% | 1.5% | 1.5% | 1.7% | 1.5% | 1.6% |
| | | | Depth of relief (Water-developability) | 1.6 mm | 1.5 mm | 1.5 mm | 1.5 mm | 1.4 mm | 1.1 mm |

LiOH: lithium hydroxide, NaOH: sodium hydroxide, Na₂CO₃: sodium carbonate, CaCO₃: calcium carbonate, ×: no neutralization with metal

| | | | Examples | | | | | |
|---|---|---|---|---|---|---|---|---|
| | | | 7 | 8 | 9 | 10 | 11 | 12 |
| Composition of photosensitive resin layer | Conjugated diene-based polymer (a) obtained from water-dispersible latex | Butadiene latex | 45.0 | 45.0 | 45.0 | 45.0 | 54.7 | |
| | | Acrylonitrile-butadiene latex | 9.7 | 9.7 | 9.7 | 9.7 | | 9.7 |
| | | Styrene-butadiene latex | | | | | | 45.0 |
| | Photopolymerizable unsaturated compound (b) | Oligobutadiene acrylate | 19.0 | 19.0 | 19.0 | 19.0 | 19.0 | 19.0 |
| | | Trimethylolpropane trimethacrylate | 7.5 | 7.5 | 7.5 | 7.5 | 7.5 | 7.5 |
| | Diene-based polymer (c) having a terminal carboxyl group | Acrylonitrile-butadiene copolymer I wherein both terminals thereof have been modified with carboxyl groups | | | | | 7.0 | 7.0 |
| | | Acrylonitrile-butadiene copolymer II wherein both terminals thereof have been modified with carboxyl groups | 7.0 | | | | | |
| | | Acrylonitrile-butadiene copolymer III wherein both terminals thereof have been modified with carboxyl groups | | 7.0 | | | | |
| | | Butadiene polymer wherein both terminals thereof have been modified with carboxyl groups | | | 7.0 | | | |
| | | Isoprene polymer wherein both terminals thereof have been modified with carboxyl groups | | | | 7.0 | | |
| | Diene-based polymer having no terminal carboxyl group | Acrylonitrile-butadiene copolymer wherein both terminals thereof have been modified with amino groups | | | | | | |
| | | Acrylonitrile-butadiene copolymer containing carboxyl group in repeating unit | | | | | | |
| | | Isoprene polymer containing carboxyl group in repeating unit | | | | | | |
| | Photopolymerization initiator (d) | | 1 | 1 | 1 | 1 | 1 | 1 |
| | Metal used to convert carboxyl groups in the diene-based polymer (c) having a terminal carboxyl group into a metal salt | | LiOH | LiOH | LiOH | LiOH | LiOH | LiOH |
| | Plasticizer | Butadiene oligomer | 10.7 | 10.7 | 10.7 | 10.7 | 10.7 | 10.7 |
| Evaluation | Water absorption rate (Durability against aqueous ink) | | 1.4% | 1.2% | 1.3% | 1.7% | 1.1% | 1.4% |
| | Depth of relief (Water-developability) | | 1.3 mm | 1.2 mm | 1.0 mm | 1.0 mm | 1.1 mm | 1.0 mm |

LiOH: lithium hydroxide, NaOH: sodium hydroxide, $Na_2CO_3$: sodium carbonate, $CaCO_3$: calcium carbonate, ×: no neutralization with metal

| | | | Comparative Examples | | | | | |
|---|---|---|---|---|---|---|---|---|
| | | | 1 | 2 | 3 | 4 | 5 | 6 |
| Composition of photosensitive resin layer | Conjugated diene-based polymer (a) obtained from water-dispersible latex | Butadiene latex | 45.0 | 45.0 | 39.0 | 45.0 | 45.0 | 45.0 |
| | | Acrylonitrile-butadiene latex | 9.7 | 9.7 | 6.0 | 9.7 | 9.7 | 9.7 |
| | | Styrene-butadiene latex | | | | | | |
| | Photopolymerizable unsaturated compound (b) | Oligobutadiene acrylate | 19.0 | 19.0 | 17.0 | 19.0 | 19.0 | 19.0 |
| | | Trimethylolpropane trimethacrylate | 7.5 | 7.5 | 6.4 | 7.5 | 7.5 | 7.5 |
| | Diene-based polymer (c) having a terminal carboxyl group | Acrylonitrile-butadiene copolymer I wherein both terminals thereof have been modified with carboxyl groups | 7.0 | | | | | |
| | | Acrylonitrile-butadiene copolymer II wherein both terminals thereof have been modified with carboxyl groups | | | | | | 7.0 |
| | | Acrylonitrile-butadiene copolymer III wherein both terminals thereof have been modified with carboxyl groups | | | | | | |
| | | Butadiene polymer wherein both terminals thereof have been modified with carboxyl groups | | | | | | |
| | | Isoprene polymer wherein both terminals thereof have been modified with carboxyl groups | | | | | | |
| | Diene-based polymer having no terminal carboxyl group | Acrylonitrile-butadiene copolymer wherein both terminals thereof have been modified with amino groups | | 7.0 | | | | |
| | | Acrylonitrile-butadiene copolymer containing carboxyl group in repeating unit | | | 25.0 | 7.0 | | |
| | | Isoprene polymer containing carboxyl group in repeating unit | | | | | 7.0 | |
| | Photopolymerization initiator (d) | | 1 | 1 | 1 | 1 | 1 | 1 |
| | Metal used to convert carboxyl groups in the diene-based polymer (c) having a terminal carboxyl group into a metal salt | | × | × | LiOH | LiOH | LiOH | × (neutralization with amine instead of conversion into metal salt) |
| | Plasticizer | Butadiene oligomer | 10.7 | 10.7 | 5.5 | 10.7 | 10.7 | 10.7 |
| Evaluation | Water absorption rate (Durability against aqueous ink) | | 1.0% | 0.8% | 3.0% | 1.8% | 1.6% | 2.8% |
| | Depth of relief (Water-developability) | | 0.4 mm | 0.3 mm | 1.4 mm | 0.8 mm | 0.2 mm | 1.1 mm |

LiOH: lithium hydroxide, NaOH: sodium hydroxide, $Na_2CO_3$: sodium carbonate, $CaCO_3$: calcium carbonate, ×: no neutralization with metal

As is clear from Table 1, Examples 1 to 12 satisfying the requirements of the present invention all exhibit a low water absorption rate (that is, excellent durability against aqueous ink) and a great depth of the relief (that is, excellent water-developability). When the diene-based polymer has a terminal carboxyl group, excellent water-developability is exhibited while the flexographic printing plate keeps the durability against aqueous ink (comparison between Example 3 and Comparative Example 4 and between Example 10 and Comparative Example 5). Further, even when the content of the diene-based polymer having a terminal carboxyl group is increased, excellent water-developability is exhibited while the flexographic printing plate keeps the durability against aqueous ink (comparison between Examples 1 to 3 and Comparative Examples 3 to 4). Further, when the bound acrylonitrile content is increased, the water-developability is improved (comparison between Example 3 and Examples 7 to 8). Further, when the metal salt of the diene-based polymer having a terminal carboxyl group is an alkali metal salt, the water-developability is improved (comparison between Examples 3 to 5 and Example 6). Further, when the conjugated diene-based polymer (a) obtained from water-dispersible latex contains both butadiene latex and acrylonitrile-butadiene latex, the water-developability is improved (comparison between Example 3 and Examples 11 to 12).

In Comparative Example 1, however, since the terminal carboxyl groups are not converted into a metal salt, the hydrophilicity is lowered and the water-developability is considerably poor. In Comparative Example 2, since the diene-based polymer has no terminal carboxyl group, the hydrophilicity is further lower and the water-developability is further poorer than those in Comparative Example 1. Comparative Examples 3 to 5 are examples of the use of a diene-based polymer having a carboxyl group in a repeating unit but not having a terminal carboxyl group. In both Comparative Examples 3 and 4, an acrylonitrile-butadiene copolymer is used as the diene-based polymer but the content thereof is different therebetween. In Comparative Example 5, an isoprene polymer is used as the diene-based polymer. As is clear from the comparison between Comparative Examples 3 and 4, when the content of an acrylonitrile-butadiene copolymer containing a carboxyl group in a repeating unit is increased, the water-developability is improved but the durability against aqueous ink is considerably degraded. As is clear from the comparison between Comparative Examples 4 and 5, Comparative Example 5 in which an isoprene polymer is used as the diene-based polymer is considerably poorer in water-developability than Comparative Example 4 in which an acrylonitrile-butadiene copolymer is used as the diene-based polymer. Since terminal carboxyl groups are neutralized with an amine instead of being converted into a metal salt, Comparative Example 6 is poorer in durability against aqueous ink than Example 7.

Industrial Applicability

The flexographic printing original plate obtained using the photosensitive resin composition according to the present invention has a feature of maintaining durability against aqueous ink and having excellent water-developability, and therefore enables high-quality mass printing. Accordingly, the present invention is very useful in this industry.

**Claims**

1. A photosensitive resin composition for a flexographic printing original plate, wherein the photosensitive resin composition contains at least: a conjugated diene-based polymer (a) obtained from water-dispersible latex; a photopolymerizable unsaturated compound (b); a diene-based polymer (c) having a terminal carboxyl group; and a photopolymerization initiator (d), **characterized in that** the terminal carboxyl group of the diene-based polymer (c) having a terminal carboxyl group is a metal salt.

2. The photosensitive resin composition for a flexographic printing original plate according to claim 1, wherein the component (c) contains an acrylonitrile skeleton and has a bound acrylonitrile content of 15 mol% or more in the component (c).

3. The photosensitive resin composition for a flexographic printing original plate according to claim 1 or 2, wherein the metal salt of the component (c) is an alkali metal salt.

4. The photosensitive resin composition for a flexographic printing original plate according to any one of claims 1 to 3, wherein the component (c) is contained in a proportion of 1 to 30 mass% in the total components of the photosensitive resin composition.

5. The photosensitive resin composition for a flexographic printing original plate according to any one of claims 1 to 4, wherein the component (a) contains at least one type of latex selected from the group consisting of butadiene latex, acrylonitrile-butadiene latex, styrene-butadiene latex, and isoprene latex.

6. The photosensitive resin composition for a flexographic printing original plate according to any one of claims 1 to 5, wherein the component (a) contains butadiene latex and acrylonitrile-butadiene latex.

7. A flexographic printing original plate **characterized by** comprising, on a support, a photosensitive resin layer produced by using the photosensitive resin composition for a flexographic printing original plate according to any one of claims 1 to 6.

## INTERNATIONAL SEARCH REPORT

| International application No. |
|---|
| **PCT/JP2022/014109** |

### A.    CLASSIFICATION OF SUBJECT MATTER

***B41C 1/00***(2006.01)i; ***B41N 1/00***(2006.01)i; ***C08F 279/02***(2006.01)i; ***G03F 7/00***(2006.01)i; ***G03F 7/027***(2006.01)i
FI:    G03F7/027 502; G03F7/00 502; B41N1/00; B41C1/00; C08F279/02

According to International Patent Classification (IPC) or to both national classification and IPC

### B.    FIELDS SEARCHED

Minimum documentation searched (classification system followed by classification symbols)

B41C1/00; B41N1/00; C08F279/02; G03F7/00; G03F7/027

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C.    DOCUMENTS CONSIDERED TO BE RELEVANT

| Category* | Citation of document, with indication, where appropriate, of the relevant passages | Relevant to claim No. |
|---|---|---|
| X | JP 10-339951 A (TOYOBO CO., LTD.) 22 December 1998 (1998-12-22)<br>claims, examples | 1-7 |
| X | JP 03-198058 A (TOYOBO CO., LTD.) 29 August 1991 (1991-08-29)<br>claims, examples | 1-7 |
| A | JP 05-072731 A (TORAY IND., INC.) 26 March 1993 (1993-03-26)<br>claims, examples | 1-7 |

☐ Further documents are listed in the continuation of Box C.      ☑ See patent family annex.

| | |
|---|---|
| \*    Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **03 June 2022** | **14 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2022/014109**

| Patent document cited in search report | | | Publication date (day/month/year) | Patent family member(s) | | | Publication date (day/month/year) |
|---|---|---|---|---|---|---|---|
| JP | 10-339951 | A | 22 December 1998 | US | 6245483 | B1 | |
| | | | | claims, examples | | | |
| | | | | EP | 884649 | A2 | |
| | | | | TW | 408250 | B | |
| | | | | KR | 10-1999-0006622 | A | |
| JP | 03-198058 | A | 29 August 1991 | US | 2001/0005569 | A1 | |
| | | | | claims, examples | | | |
| | | | | EP | 398325 | A3 | |
| | | | | CA | 2016919 | A | |
| | | | | KR | 10-1990-0017797 | A | |
| JP | 05-072731 | A | 26 March 1993 | (Family: none) | | | |

Form PCT/ISA/210 (patent family annex) (January 2015)

**REFERENCES CITED IN THE DESCRIPTION**

**Patent documents cited in the description**

- JP 2005148588 A
- JP 2011203453 A
- JP 2017076059 A